# EUROPEAN PATENT APPLICATION

(11) **EP 4 726 226 A1**
(43) Date of publication of application: **15.04.2026**
(21) Application number: 24919713.8
(22) Date of filing: 28.08.2024
(51) Int. Cl.: F16C 11/04, H04M 1/02

(54) **ROTATING SHAFT MECHANISM AND ELECTRONIC DEVICE**

(30) Priority: 23.01.2024 CN 202410099988
(71) Applicant: Huawei Technologies Co., Ltd., Shenzhen, Guangdong 518129 (CN)
(72) Inventor: PENG, Lexiong, Shenzhen, Guangdong 518129 (CN); ZHAO, Jie, Shenzhen, Guangdong 518129 (CN); TU, Yiming, Shenzhen, Guangdong 518129 (CN); BAI, Lei, Shenzhen, Guangdong 518129 (CN); WEI, Qinan, Shenzhen, Guangdong 518129 (CN); HE, Yukun, Shenzhen, Guangdong 518129 (CN)
(74) Representative: Goddar, Heinz J.
(86) International application number: PCT/CN2024/115271
(87) International publication number: WO 2025/156632

(57) **Abstract**

A hinge mechanism (1) and an electronic device are provided. The hinge mechanism (1) includes a main shaft module (101) and two support plates, the main shaft module (101) includes two rotating components, two housing mounting brackets, and a main shaft (1013). The two rotating components are located on two opposite sides of the main shaft (1013). A support arm of the rotating component is rotatably connected to the main shaft (1013), and is slidably connected to a housing mounting bracket disposed on a same side. Each support plate is rotatably connected to a housing mounting bracket disposed on a same side. When the hinge mechanism (1) is in a closed state, the two support plates and the main shaft (1013) enclose a screen accommodating space (7), and an end part that is of each support plate and that is close to the main shaft (1013) is disposed opposite to a step surface of a support arm disposed on a same side. In this way, when the hinge mechanism (1) is impacted by an external load, the end part that is of the support plate and that is close to the main shaft (1013) abuts against the corresponding step surface, so that an internal force transmission path of the main shaft module (101) can be effectively improved, to reduce a displacement amount between the support arm and the housing mounting bracket, so as to improve structural reliability of the hinge mechanism (1), and further improve structural reliability of the electronic device.

## Description

### CROSS-REFERENCE TO RELATED APPLICATIONS

This application claims priority to Chinese Patent Application No. 202410099988.5, filed with the China National Intellectual Property Administration on January 23, 2024 and entitled "HINGE MECHANISM AND ELECTRONIC DEVICE", which is incorporated herein by reference in its entirety.

### TECHNICAL FIELD

This application relates to the field of foldable electronic device technologies, and in particular, to a hinge mechanism and an electronic device.

### BACKGROUND

As flexible display technologies gradually become mature, display manners of electronic devices are driven to greatly change. A mobile phone with a foldable flexible display, a tablet computer with a foldable flexible display, a wearable electronic device with a foldable flexible display, and the like are important evolution directions of intelligent electronic devices in the future.

As a key component in a foldable electronic device, a hinge mechanism may be configured to implement a folding function of the foldable electronic device, and may further provide a folding feel. In addition, when the foldable electronic device is in an unfolded state, the hinge mechanism may be configured to support a flexible display; and when the foldable electronic device is in a closed state, the hinge mechanism may be configured to accommodate the flexible display, so that the hinge mechanism protects the flexible display. However, when the foldable electronic device is in the closed state, a spacing between a bent part of the flexible display and the hinge mechanism is small. If internal parts of the hinge mechanism are displaced or deformed under an external load, the flexible display may be collided, and this easily causes damage to the flexible display.

Based on this, how to improve structural reliability of the hinge mechanism has become an urgent difficult problem to be resolved by a person skilled in the art.

### SUMMARY

This application provides a hinge mechanism and an electronic device, to improve structural reliability of the hinge mechanism, reduce a risk of damage to a flexible display, and improve structural reliability of the electronic device.

According to a first aspect, this application provides a hinge mechanism. The hinge mechanism is used in a foldable electronic device, and the hinge mechanism is at least partially disposed corresponding to a foldable part of a flexible display of the electronic device. When the hinge mechanism is specifically disposed, the hinge mechanism may include a main shaft module, a first support plate, and a second support plate, the main shaft module includes a first rotating component, a second rotating component, a first housing mounting bracket, a second housing mounting bracket, and a main shaft, and the first rotating component and the second rotating component are located on two opposite sides of the main shaft. The first rotating component includes a first support arm, the first support arm is rotatably connected to the main shaft, the first support arm is slidably connected to the first housing mounting bracket, and the first support arm includes a first step surface, where the first step surface is located on a side that is of the first support arm and that faces the flexible display. The second rotating component includes a second support arm, the second support arm is rotatably connected to the main shaft, the second support arm is slidably connected to the second housing mounting bracket, and the second support arm includes a second step surface, where the second step surface is located on a side that is of the second support arm and that faces the flexible display. The first support plate is rotatably connected to the first housing mounting bracket, the first support plate includes a first plate surface, and the first plate surface is configured to connect to the flexible display. The second support plate is rotatably connected to the second housing mounting bracket, the second support plate includes a third plate surface, and the third plate surface is configured to connect to the flexible display. When the hinge mechanism is in a closed state, a screen accommodating space is formed between the first plate surface of the first support plate, the third plate surface of the second support plate, and a surface that is of the main shaft and that faces the first support plate and the second support plate; and at least a part of an end part that is of the first support plate and that is close to the main shaft is disposed opposite to the first step surface, and at least a part of an end part that is of the second support plate and that is close to the main shaft is disposed opposite to the second step surface. When the hinge mechanism provided in this application is in the closed state, and the main shaft is subjected to an external load, the at least a part of the end part that is of the first support plate and that is close to the main shaft abuts against the first step surface, and the at least a part of the end part that is of the second support plate and that is close to the main shaft abuts against the second step surface, to reduce a displacement amount between the first support arm and the first housing mounting bracket and a displacement amount between the second support arm and the second housing mounting bracket, so as to limit a deformation amount of the main shaft, and improve structural reliability of the hinge mechanism. This can help reduce a risk of squeezing caused by the hinge mechanism to a part that is of the flexible display and that is accommodated in the screen accommodating space, to improve structural reliability of the electronic device in which the hinge mechanism is used.

It may be understood that, when the hinge mechanism is in the closed state, a spacing between the first step surface and the at least a part of the end part that is of the first support plate and that is close to the main shaft, and a spacing between the second step surface and the at least a part of the end part that is of the second support plate and that is close to the main shaft may be adjusted based on a specific design size of the hinge mechanism, provided that a deformation amount of the main shaft can be reduced through abutting between the at least a part of the end part that is of the first support plate and that is close to the main shaft and the first step surface and abutting between the at least a part of the end part that is of the second support plate and that is close to the main shaft and the second step surface when the main shaft is subjected to a specific external load.

In a possible implementation of this application, the main shaft includes a main inner shaft and a main outer shaft, and the main inner shaft and the main outer shaft are disposed in a snap-fit manner. When the hinge mechanism is in the closed state, a projection of the end part that is of the first support plate and that is close to the main shaft in a direction from the main inner shaft to the main outer shaft at least partially overlaps a projection of the first step surface in the direction from the main inner shaft to the main outer shaft; and a projection of the end part that is of the second support plate and that is close to the main shaft in the direction from the main inner shaft to the main outer shaft at least partially overlaps a projection of the second step surface in the direction from the main inner shaft to the main outer shaft. In this way, when the main shaft of the hinge mechanism is subjected to an external load in a direction from the main outer shaft to the main inner shaft, the end part that is of the first support plate and that is close to the main shaft can abut against the first step surface, and the end part that is of the second support plate and that is close to the main shaft can abut against the second step surface, so that the deformation amount of the main shaft can be reduced.

In a possible implementation of this application, the first support plate includes a first latch hook, the first latch hook is located on a side that is of the first support plate and that is away from the first plate surface, and an included angle that is between the first plate surface and an extension direction of the first latch hook and that is away from the main shaft is an acute angle. In addition, the first support arm further includes a first latch slot. When the hinge mechanism is in the closed state, the first latch hook interlocks with the first latch slot. In this way, when the main shaft module is subjected to the external load, the first latch hook may interlock with the first latch slot, to prevent the end part that is of the first support plate and that is close to the main shaft from sliding off the first step surface, so as to improve abutting reliability of the first support plate and the first support arm, and improve structural reliability of the hinge mechanism.

Similarly, the second support plate includes a second latch hook, the second latch hook is located on a side that is of the second support plate and that is away from the third plate surface, and an included angle that is between the third plate surface and an extension direction of the second latch hook and that is away from the main shaft is an acute angle. The second support arm further includes a second latch slot. When the hinge mechanism is in the closed state, the second latch hook interlocks with the second latch slot. In this way, when the main shaft module is subjected to the external load, the second latch hook may interlock with the second latch slot, to prevent the end part that is of the second support plate and that is close to the main shaft from sliding off the second step surface, so as to improve abutting reliability of the second support plate and the second support arm, and improve structural reliability of the hinge mechanism.

In a possible implementation of this application, the first support plate includes a first plate portion and a second plate portion, the first plate portion is fastened to the second plate portion, a strength of the second plate portion is greater than a strength of the first plate portion, and the second plate portion is disposed close to the main shaft relative to the first plate portion. In this way, the strength of the end part that is of the first support plate and that is close to the main shaft may be relatively large. This can reduce a risk of damage of the first support plate, to improve structural reliability of the hinge mechanism.

Similarly, the second support plate may include a third plate portion and a fourth plate portion, the third plate portion is fastened to the fourth plate portion, a strength of the fourth plate portion is greater than a strength of the third plate portion, and the fourth plate portion is disposed close to the main shaft relative to the third plate portion. In this way, the strength of the end part that is of the second support plate and that is close to the main shaft may be relatively large. This can reduce a risk of damage of the second support plate, to improve structural reliability of the hinge mechanism.

During actual design, the first plate portion may be made of a material with a light weight like aluminum, and the second plate portion may be made of a material with high structural strength like stainless steel. In this way, the structural reliability of the first support plate is ensured, and an overall weight of the first support plate can be prevented from being excessively large, to meet a lightweight design requirement of the hinge mechanism. In addition, the first plate portion and the second plate portion may be fastened in a manner of welding, riveting, threaded connection, or the like, to ensure reliability of connection between the first plate portion and the second plate portion.

Similarly, the material of the third plate portion may also be aluminum, and the material of the fourth plate portion may also be stainless steel. In addition, the third plate portion and the fourth plate portion may also be fastened in a manner of welding, riveting, threaded connection, or the like. In this way, structural reliability of the second support plate is ensured, and an overall weight of the second support plate can be prevented from being excessively large, to meet a lightweight design requirement of the hinge mechanism.

Based on the setting manners of the first support plate and the second support plate in the foregoing implementation, in a possible implementation of this application, the first latch hook and the second plate portion may be of an integrated structure, and the second latch hook and the fourth plate portion may be of an integrated structure. In this way, strengths of the first latch hook and the second latch hook can be effectively improved, and integration of the first support plate and the second support plate can be improved. This helps simplify a structure of the main shaft module.

In a possible implementation of this application, to implement sliding connection between the first support arm and the first housing mounting bracket, the first housing mounting bracket includes a first sliding groove, and the first support arm is slidably mounted to the first sliding groove.

Similarly, the second housing mounting bracket includes a second sliding groove, and the second support arm is slidably mounted to the second sliding groove. In this way, the second support arm is slidably connected to the second housing mounting bracket.

In a possible implementation of this application, the first rotating component further includes a first swing arm, the first swing arm is rotatably connected to the main shaft, the first swing arm is rotatably connected to the first housing mounting bracket, and an axis along which the first swing arm rotates around the main shaft is parallel to and does not overlap an axis along which the first support arm rotates around the main shaft. Similarly, the second rotating component further includes a second swing arm, the second swing arm is rotatably connected to the main shaft, the second swing arm is rotatably connected to the second housing mounting bracket, and an axis along which the second swing arm rotates around the main shaft is parallel to and does not overlap an axis along which the second support arm rotates around the main shaft. In this way, in a rotation process of the hinge mechanism, a phase difference motion between axis centers of the support arm and the swing arm that are disposed on a same side can be implemented, to implement telescopic movement of the two rotating components, so that the flexible display of the electronic device can be stably supported when the hinge mechanism is in the unfolded state, and when the hinge mechanism is in the closed state, a screen accommodating space that meets a bending requirement of the flexible display can be formed.

To implement rotational connection between the first swing arm and the second swing arm and the main shaft, in a possible implementation of this application, the main shaft is provided with a first arc-shaped groove and a second arc-shaped groove, the first swing arm includes a first arc-shaped rotating block, and the first arc-shaped rotating block is mounted to the first arc-shaped groove, and is capable of sliding along a groove surface of the first arc-shaped groove. The second swing arm includes a second arc-shaped rotating block, and the second arc-shaped rotating block is mounted to the second arc-shaped groove, and is capable of sliding along a groove surface of the second arc-shaped groove. In this design, the first swing arm and the second swing arm can be rotatably connected to the main shaft through a virtual shaft, so that spaces occupied by the first swing arm and the second swing arm on the main shaft can be effectively reduced, to facilitate miniaturization design of the hinge mechanism.

In a possible implementation of this application, the first support plate further includes a second plate surface, the second plate surface is disposed opposite to the first plate surface, a second rotating portion is disposed on the second plate surface, and the first housing mounting bracket is provided with a first rotating groove. In this way, the first rotating portion may be mounted to the first rotating groove, so that the first rotating portion slides along a groove surface of the first rotating groove, to implement rotational connection between the first support plate and the first housing mounting bracket.

Similarly, the second support plate further includes a fourth plate surface, the fourth plate surface is disposed opposite to the third plate surface, a second rotating portion is disposed on the fourth plate surface, and the second housing mounting bracket is provided with a second rotating groove. In this way, the second rotating portion is mounted to the second rotating groove, so that the second rotating portion may slide along a groove surface of the second rotating groove, to implement rotational connection between the second support plate and the second housing mounting bracket.

To enable the first support plate and the second support plate to rotate around the corresponding housing mounting brackets, in a possible implementation of this application, the second plate surface of the first support plate is provided with a first guide portion, the first guide portion includes a first track groove, at least one of the first support arm and the first swing arm is provided with a first guide structure, and the first guide structure is inserted into the first track groove, and is capable of sliding along the first track groove.

Similarly, the fourth plate surface of the second support plate is further provided with a second guide portion, and the second guide portion includes a second track groove. At least one of the second support arm and the second swing arm is provided with a second guide structure, and the second guide structure is inserted into the second track groove, and is capable of sliding along the second track groove.

In this way, when the first housing mounting bracket and the second housing mounting bracket rotate towards each other, the first guide structure slides in the first track groove, to drive an end that is of the first support plate and that is close to the main shaft to move in a direction away from the main shaft, and the second guide structure slides in the second track groove, to drive an end that is of the second support plate and that is close to the main shaft to move in the direction away from the main shaft, so that a screen accommodating space can be formed between the two support plates and the main shaft. In addition, when the first housing mounting bracket and the second housing mounting bracket rotate away from each other, the first guide structure may slide in the first track groove, to drive the end that is of the first support plate and that is close to the main shaft to move towards the main shaft, and the second guide structure slides in the second track groove, to drive the end that is of the second support plate and that is close to the main shaft to move towards the main shaft, so that a flat support surface can be formed by the first support plate, the second support plate, and the main shaft in the unfolded state.

According to a second aspect, this application further provides an electronic device, and the electronic device includes a first housing, a second housing, a flexible display, and a hinge mechanism according to the first aspect. The first housing and the second housing are respectively disposed on two opposite sides of the hinge mechanism, a first housing mounting bracket is fastened to the first housing, and a second housing mounting bracket is fastened to the second housing. The flexible display continuously covers the first housing, the second housing, and the hinge mechanism, and the flexible display is fastened to the first housing and the second housing. When the electronic device provided in this application is in a closed state, a risk that a bent part of the flexible display is squeezed by the hinge mechanism and fails is low. Therefore, structural reliability of the electronic device is good.

### BRIEF DESCRIPTION OF DRAWINGS

FIG. 1 is a diagram of an electronic device in a closed state according to an embodiment of this application;
FIG. 2 is a diagram of an electronic device in an unfolded state according to an embodiment of this application;
FIG. 3 is an exploded view of the electronic device shown in FIG. 2;
FIG. 4 is a diagram of a structure of a main shaft module when a hinge mechanism is in an unfolded state according to an embodiment of this application;
FIG. 5 is a diagram of a partial structure of the main shaft module shown in FIG. 4;
FIG. 6 is an exploded view of the structure shown in FIG. 5;
FIG. 7 is a diagram of a structure of a first support plate according to an embodiment of this application;
FIG. 8 is a diagram of a structure of a main shaft module when a hinge mechanism is in a closed state according to an embodiment of this application;
FIG. 9 is a block diagram of a structure in which the hinge mechanism in the closed state shown in FIG. 8 cooperates with a bendable part of a flexible display;
FIG. 10 is a side view of the main shaft module shown in FIG. 8;
FIG. 11 is a sectional view of a main shaft module in a closed state in the conventional technology according to an embodiment of this application;
FIG. 12 is a sectional view of a first support arm and a second support arm of a main shaft module in a closed state according to an embodiment of this application;
FIG. 13 is a strain comparison diagram of a flexible display when the main shaft module shown in FIG. 11 and the main shaft module shown in FIG. 12 are subjected to an external load;
FIG. 14 is an enlarged view of a partial structure of a location A of the main shaft module shown in FIG. 12; and
FIG. 15 is a diagram of a structure of a main shaft module in an intermediate state according to an embodiment of this application.

Reference numerals:
1: hinge mechanism; 101: main shaft module;
1011: first rotating component; 10111: first swing arm; 101111: first arc-shaped rotating block; 101112: first guide structure;
10112: first support arm;
101121: first step surface; 101122: first latch slot; 101123: first sliding block;
1012: second rotating component; 10121: second swing arm; 10122: second support arm;
101221: second step surface; 101222: second latch slot; 101223: second sliding block;
1013: main shaft; 10131: main outer shaft; 101311: first arc-shaped groove; 10132: main inner shaft;
1014: first housing mounting bracket; 10141: first sliding groove; 10142: first rotating groove;
1015: second housing mounting bracket; 10151: second sliding groove; 10152: second rotating groove;
1016: first support plate; 10161: first plate surface; 10162: second plate surface; 101621: first rotating portion; 101622: first guide portion;
1016221: first track groove; 101623: first latch hook; 1016a: first plate portion; 1016b: second plate portion;
1017: second support plate; 10171: third plate surface; 10173: second latch hook; 1017a: third plate portion;
1017b: fourth plate portion;
2: first housing; 201: support surface of the first housing; 3: second housing; 301: support surface of the second housing; 4: flexible display;
5: first appearance cover; 6: second appearance cover; 7: screen accommodating space.

### DESCRIPTION OF EMBODIMENTS

To make the objectives, technical solutions, and advantages of this application clearer, the following further describes this application in detail with reference to the accompanying drawings. However, example implementations can be implemented in a plurality of forms, and should not be construed as being limited to the implementations described herein. Identical reference numerals in the accompanying drawings denote identical or similar structures. Therefore, repeated descriptions thereof are omitted. Expressions of locations and directions in embodiments of this application are described by using the accompanying drawings as an example. However, changes may also be made as required, and all the changes fall within the protection scope of this application. The accompanying drawings in embodiments of this application are merely used to illustrate relative location relationships and do not represent an actual scale.

It should be noted that specific details are set forth in the following descriptions for ease of understanding this application. However, this application can be implemented in a plurality of manners different from those described herein, and a person skilled in the art can perform similar promotion without departing from the connotation of this application. Therefore, this application is not limited to the specific implementations disclosed below.

To facilitate understanding of a hinge mechanism provided in this application, the following first describes an application scenario of the hinge mechanism. The hinge mechanism may be but is not limited to being used in a foldable electronic device like a mobile phone, a personal digital assistant (personal digital assistant, PDA), a notebook computer, or a tablet computer.

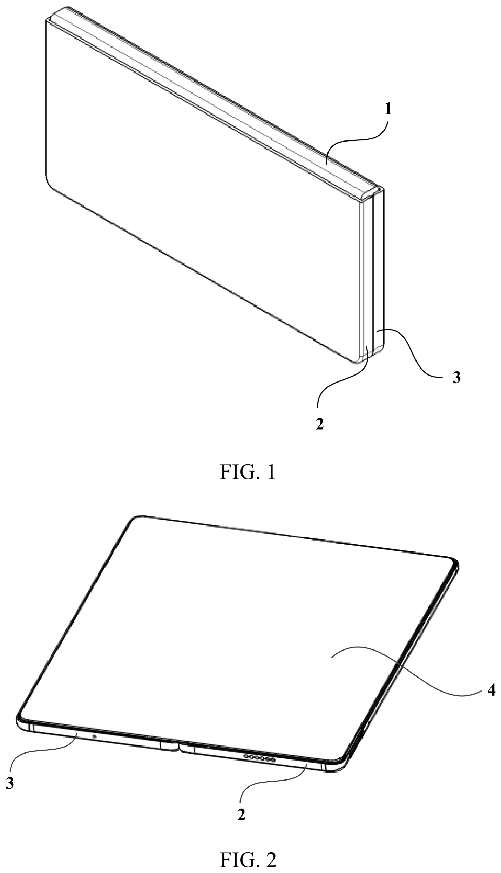

FIG. 1 is a diagram of a structure of an electronic device in a closed state according to an embodiment of this application. In addition to a hinge mechanism 1, the electronic device may further include two housings and a flexible display (not shown in FIG. 1). For ease of description, in this application, the two housings of the electronic device may be respectively named a first housing 2 and a second housing 3. The first housing 2 and the second housing 3 are located on two sides of the hinge mechanism 1, and can rotate around the hinge mechanism 1. The electronic device provided in this application may be an inward folded electronic device. When being used, the electronic device may be closed or unfolded according to different use scenarios.

FIG. 2 is a diagram of a structure of an electronic device in an unfolded state. A flexible display 4 may continuously cover the first housing 2, the second housing 3, and the hinge mechanism 1 (not shown in FIG. 2, and reference may be made to FIG. 1). In this case, when the electronic device is in the unfolded state shown in FIG. 2, the hinge mechanism 1, the first housing 2, and the second housing 3 may play a role of flat support for the flexible display 4.

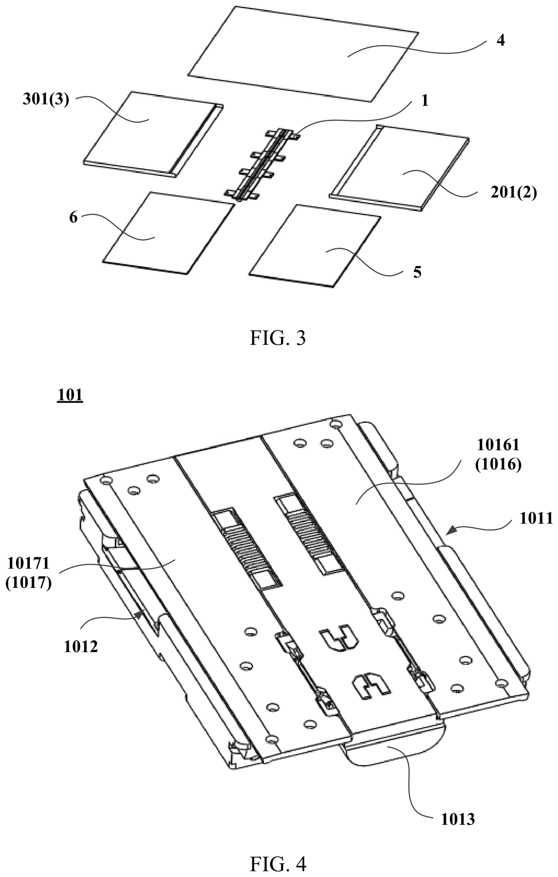

FIG. 3 is an exploded view of the electronic device shown in FIG. 2. In this embodiment of this application, the flexible display 4 may be connected to a support surface 201 of the first housing and a support surface 301 of the second housing, and a connection manner may be but is not limited to bonding. In addition to the foregoing structure, the electronic device provided in this application may further include a first appearance cover 5 and a second appearance cover 6. The first appearance cover 5 is disposed on a side that is of the first housing 2 and that is away from the flexible display 4, and the second appearance cover 6 is disposed on a side that is of the second housing 3 and that is away from the flexible display 4. The first appearance cover 5 and the second appearance cover 6 may be used as protection covers of the electronic device, to protect the electronic device and improve appearance of the electronic device.

It may be understood that a process in which the electronic device changes from the unfolded state shown in FIG. 2 to the closed state shown in FIG. 1, or from the closed state shown in FIG. 1 to the unfolded state shown in FIG. 2 is a process in which the first housing 2 and the second housing 3 rotate around the hinge mechanism 1. In this process, the flexible display 4 may be bent or unfolded with the first housing 2 and the second housing 3. As a key functional component in the foldable electronic device, the hinge mechanism 1 may be disposed corresponding to a bendable part of the flexible display 4. Therefore, the hinge mechanism 1 is important in both supporting the bendable part of the flexible display 4 in the unfolded state shown in FIG. 2, and accommodating and protecting the bendable part of the flexible display 4 in the closed state shown in FIG. 1.

Currently, to meet a design requirement of lightness and thinness of the electronic device, a disposing space of a structure of each part of the electronic device is compressed. When the electronic device is in the closed state, the hinge mechanism provides a small accommodating space for the bendable part of the flexible display. In addition, due to a design tolerance of the flexible display and the hinge mechanism, when the electronic device is impacted by an external load, parts of the hinge mechanism may be deformed or displaced. These cause a small spacing between the bendable part of the flexible display and the part of the hinge mechanism, and even cause the bendable part of the flexible display to be squeezed. However, the bendable part of the flexible display has a large internal stress. When the bendable part is squeezed due to an external load, the flexible display is prone to a failure like a bright spot or a black spot under the action of stress superposition.

In view of this, the hinge mechanism provided in this application adds a structure that can protect the flexible display, to improve structural reliability of the hinge mechanism, and reduce a risk of a failure of the flexible display due to squeezing, so as to prolong a service life of the flexible display, and improve overall structural reliability of the electronic device in which the hinge mechanism is used. To facilitate understanding of the technical solutions of this application, the following specifically describes an antenna provided in this application with reference to the accompanying drawings and specific implementations.

In this application, to implement a rotation function, the hinge mechanism 1 may include one main shaft module, or may include a plurality of main shaft modules. For example, in the electronic device shown in FIG. 3, the hinge mechanism includes four main shaft modules. When the hinge mechanism 1 includes a plurality of main shaft modules 101, the plurality of main shaft modules 101 may be spaced from each other in an axial direction of the hinge mechanism 1. In this application, the axial direction of the hinge mechanism 1 is an extension direction of an axis along which the first housing 2 and the second housing 3 rotate around the hinge mechanism 1. It may be understood that the first housing 2 and the second housing 3 are rotatably connected via the plurality of main shaft modules 101. This can effectively improve stability of rotation of the first housing 2 and the second housing 3 of the electronic device relative to the hinge mechanism 1.

FIG. 4 is a diagram of a structure of the main shaft module 101 when a hinge mechanism is in an unfolded state according to an embodiment of this application. The main shaft module 101 includes a first rotating component 1011, a second rotating component 1012, and a main shaft 1013. The main shaft 1013 may be used as a bearing component of the first rotating component 1011 and the second rotating component 1012. The first rotating component 1011 and the second rotating component 1012 are respectively disposed on two opposite sides of the main shaft 1013, and are separately rotatably connected to the main shaft 1013.

It should be noted that, in a possible embodiment of this application, when the hinge mechanism 1 includes a plurality of main shaft modules 101, first rotating components 1011 and second rotating components 1012 of the plurality of main shaft modules 101 may use the same main shaft 1013 as a bearing component, to improve integration of the hinge mechanism 1. In some other possible embodiments of this application, one main shaft 1013 may be separately disposed in each main shaft module 101, so that a first rotating component 1011 and a second rotating component 1012 of each main shaft module 101 use a corresponding main shaft 1013 as a bearing component. This helps improve layout flexibility of each main shaft module 101.

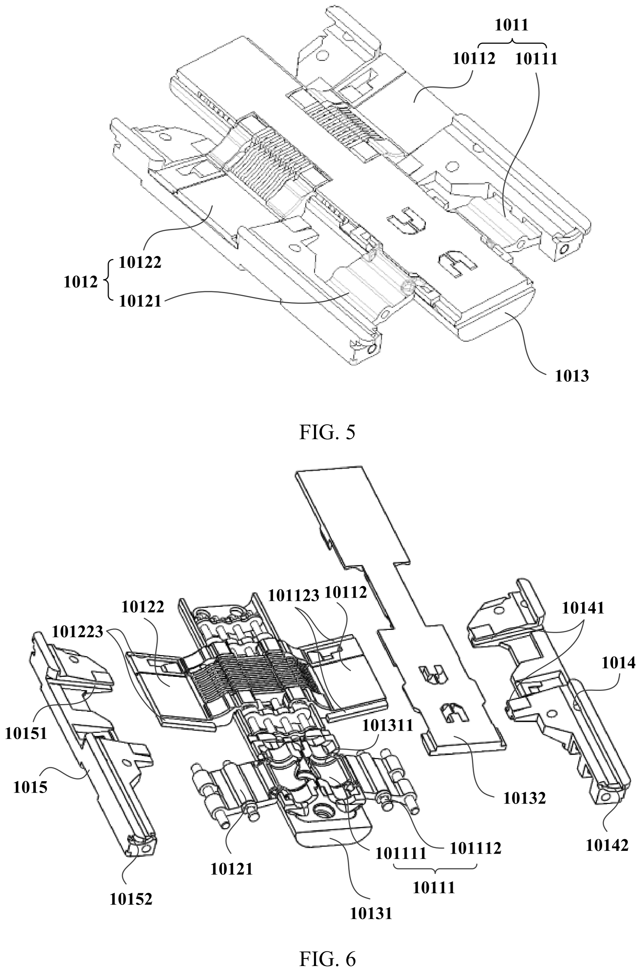

For ease of understanding of the structure of the main shaft module 101, refer to FIG. 5. FIG. 5 is a diagram of a partial structure of the main shaft module 101 shown in FIG. 4. The first rotating component 1011 includes a first swing arm 10111 and a first support arm 10112, where the first swing arm 10111 is rotatably connected to the main shaft 1013. In a possible embodiment of this application, the first swing arm 10111 and the main shaft 1013 may be rotatably connected through a virtual axis. The virtual axis is an axis center of an arc-shaped structure. Two components that are rotatably connected may rotate relative to the virtual axis, and a location of the virtual axis is fixed as relative rotation between the two components that are rotatably connected. In practice, refer to FIG. 6. FIG. 6 is an exploded view of the structure shown in FIG. 5. The main shaft 1013 includes a main outer shaft 10131 and a main inner shaft 10132. The main inner shaft 10132 and the main outer shaft 10131 are disposed in a snap-fit manner. The main outer shaft 10131 includes a first arc-shaped groove 101311, and a first mounting cavity is formed between the first arc-shaped groove 101311 and an end face that is of the main inner shaft 10132 and that faces the main outer shaft 10131. The first swing arm 10111 includes a first arc-shaped rotating block 101111, and the first arc-shaped rotating block 101111 is mounted to the first arc-shaped groove 101311. The first arc-shaped rotating block 101111 may slide along a groove surface of the first arc-shaped groove 101311. In this way, the first arc-shaped rotating block 101111 slides along the groove surface of the first arc-shaped groove 101311 in the first mounting cavity, so that the first swing arm 10111 is rotatably connected to the main shaft 1013. It may be understood that the first swing arm 10111 is rotatably connected to the main shaft 1013 through a virtual axis. This helps reduce a space occupied by the first swing arm 10111 on the main shaft 1013, to help reduce a volume of the main shaft module 101, so as to facilitate a miniaturization design of the hinge mechanism 1.

In some other possible embodiments of this application, the first swing arm 10111 may alternatively be rotatably connected to the main shaft 1013 via a physical axis, to improve reliability of connection between the first swing arm 10111 and the main shaft 1013.

In this application, the first support arm 10112 is also rotatably connected to the main shaft 1013. For example, the first support arm 10112 may be rotatably connected to the main shaft 1013 via a pin shaft, to improve reliability of connection between the first support arm 10112 and the main shaft 1013. However, in some other possible embodiments of this application, the first support arm 10112 may alternatively be rotatably connected to the main shaft 1013 through a virtual axis. This helps reduce a space occupied by the first support arm 10112 on the main shaft 1013, to help reduce the volume of the main shaft module 101, so as to facilitate the miniaturization design of the hinge mechanism 1.

Still refer to FIG. 6. In this application, for disposition of the second rotating component 1012, refer to that of the first rotating component 1011. Simply, the second rotating component 1012 includes a second swing arm 10121 and a second support arm 10122, and the second swing arm 10121 and the second support arm 10122 are also rotatably connected to the main shaft 1013. For a specific implementation of rotatably connecting the second swing arm 10121 and the main shaft 1013, refer to a manner of connecting the first swing arm 10111 and the main shaft 1013. For a specific implementation of rotatably connecting the second support arm 10122 and the main shaft 1013, refer to a manner of connecting the first support arm 10112 and the main shaft 1013. Details are not described herein again. In addition, in this application, the second rotating component 1012 and the first rotating component 1011 may be symmetrically disposed relative to the main shaft 1013. This helps simplify the structure of the main shaft module 101, so that a structure of the hinge mechanism 1 is simplified.

As shown in FIG. 6, the main shaft module 101 provided in this embodiment of this application further includes a first housing mounting bracket 1014 and a second housing mounting bracket 1015. The first housing mounting bracket 1014 is configured to fasten to the first housing of the electronic device, and the second housing mounting bracket 1015 is configured to fasten to the second housing of the electronic device. In addition, the first housing mounting bracket 1014 and the first rotating component 1011 are located on a same side of the main shaft 1013, the first housing mounting bracket 1014 includes a first sliding groove 10141, and the first support arm 10112 is slidably mounted to the first sliding groove 10141. During specific implementation, the first housing mounting bracket 1014 includes two first sliding grooves 10141, and groove opening of the two first sliding grooves 10141 are disposed opposite to each other in an axial direction of the main shaft 1013. In addition, the first support arm 10112 includes two first sliding blocks 101123, and the two first sliding blocks 101123 are slidably mounted to the two sliding grooves 10141 in a one-to-one correspondence. In this case, in a process in which the first housing mounting bracket 1014 rotates around the main shaft 1013, the two first sliding blocks 101123 of the first support arm 10112 may respectively slide in the corresponding first sliding grooves 10141 relative to the first housing mounting bracket 1014.

Still refer to FIG. 6. The first swing arm 10111 is rotatably connected to the first housing mounting bracket 1014. In an actual design, the first swing arm 10111 and the first housing mounting bracket 1014 may be rotatably connected via a pin shaft, to ensure reliability of connection between the first swing arm 10111 and the first housing mounting bracket 1014.

It may be understood that, in this embodiment of this application, a rotation axis of rotational connection between the first swing arm 10111 and the main shaft 1013 is parallel to and does not overlap a rotation axis of rotational connection between the first support arm 10112 and the main shaft 1013. In this way, when the first housing mounting bracket 1014 rotates around the main shaft 1013, the first swing arm 10111 and the first support arm 10112 may be driven to rotate around the main shaft 1013, and the first swing arm 10111 can further slide in the first sliding groove 10141 relative to the first housing mounting bracket 1014.

When the second housing mounting bracket 1015 is specifically disposed, the second housing mounting bracket 1015 and the second rotating component 1012 are located on a same side of the main shaft 1013, and the second housing mounting bracket 1015 includes two second sliding grooves 10151. For disposition of the two second sliding grooves 10151, refer to that of the two first sliding grooves 10141. Details are not described herein again. In addition, the second support arm 10122 includes two second sliding blocks 101223. For disposition of the two second sliding blocks 101223, refer to that of the two first sliding blocks 101123. Details are not described herein again. In this case, the two second sliding blocks 101223 of the second support arm 10122 are slidably mounted to the two second sliding grooves 10151 in a one-to-one correspondence. In a process in which the second housing mounting bracket 1015 rotates around the main shaft 1013, the two second sliding blocks 101223 of the second support arm 10122 may respectively slide in the corresponding second sliding grooves 10151 relative to the second housing mounting bracket 1015.

In this application, the second swing arm 10121 is rotatably connected to the second housing mounting bracket 1015. In an actual design, the second swing arm 10121 and the second housing mounting bracket 1015 may be rotatably connected via a pin shaft, to ensure reliability of connection between the second swing arm 10121 and the second housing mounting bracket 1015.

Similarly, in this embodiment of this application, a rotation axis of rotational connection between the second swing arm 10121 and the main shaft 1013 is also parallel to and does not overlap a rotation axis of rotational connection between the second support arm 10122 and the main shaft 1013. In this way, when the second housing mounting bracket 1015 rotates around the main shaft 1013, the second swing arm 10121 and the second support arm 10122 may be driven to rotate around the main shaft 1013, and the second swing arm 10121 can further slide in the second sliding groove 10151 relative to the second housing mounting bracket 1015.

Still refer to FIG. 4. In this application, the hinge mechanism 1 further includes a first support plate 1016 and a second support plate 1017. The first support plate 1016 is rotatably connected to the first housing mounting bracket 1014, and the second support plate 1017 is rotatably connected to the second housing mounting bracket 1015.

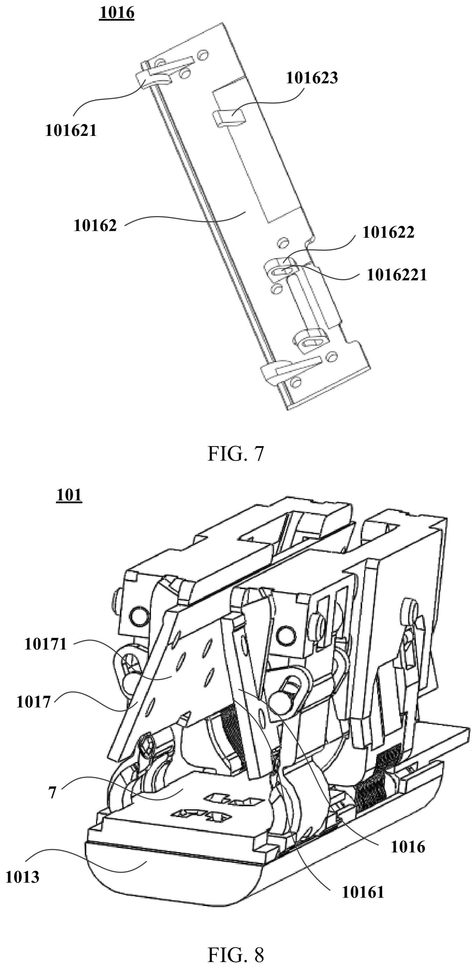

When the first support plate 1016 is specifically disposed, refer to FIG. 7. FIG. 7 is a diagram of a structure of the first support plate 1016 according to an embodiment of this application. Refer to FIG. 4 and FIG. 7 together, the first support plate 1016 includes a first plate surface 10161 and a second plate surface 10162 that are disposed opposite to each other, and the first plate surface 10161 is a plate surface that is of the first support plate 1016 and that is configured to connect to the flexible display 4. A first rotating portion 101621 is disposed on the second plate surface 10162, and the first rotating portion 101621 may be, for example, an arc-shaped rotating portion.

In addition, refer to FIG. 6. In this embodiment of this application, the first housing mounting bracket 1014 includes a first rotating groove 10142, and the first rotating groove 10142 may be an arc-shaped groove like a circular arc groove. In this case, the first rotating portion 101621 of the first support plate 1016 may be mounted to the first rotating groove 10142. In this way, the first rotating portion 101621 slides along a groove surface of the first rotating groove 10142, to implement relative rotation between the first support plate 1016 and the first housing mounting bracket 1014.

It may be understood that, to improve stability of rotation of the first support plate 1016 around the first housing mounting bracket 1014, a plurality of first rotating grooves 10142 may be disposed on the first housing mounting bracket 1014, and a plurality of first rotating portions 101621 may be disposed on the first support plate 1016. In this way, the first rotating portions 101621 may be mounted to the first rotating grooves 10142 in a one-to-one correspondence, so that each first rotating portion 101621 slides around a groove surface of a corresponding first rotating groove 10142, to implement relative rotation between the first support plate 1016 and the first housing mounting bracket 1014.

A structure of the second support plate 1017 is similar to the structure of the first support plate 1016 shown in FIG. 7. The second support plate 1017 includes a third plate surface 10171 and a fourth plate surface (not shown in FIG. 4) that are disposed opposite to each other. The third plate surface 10171 is a plate surface that is of the second support plate 1017 and that is configured to connect to the flexible display 4. A second rotating portion is disposed on the fourth plate surface. For disposition of the second rotating portion, refer to that of the first rotating portion 101621. Details are not described herein again.

In addition, the second housing mounting bracket 1015 includes a second rotating groove 10152. For disposition of the second rotating groove 10152, refer to that of the first rotating groove 10142. Details are not described herein again. In this case, the second rotating portion of the second support plate 1017 may be mounted to the second rotating groove of the second housing mounting bracket 1015, so that the second rotating portion slides along a groove surface of the second rotating groove 10152, to implement rotational connection between the second support plate 1017 and the second housing mounting bracket 1015.

Still refer to FIG. 4. In the unfolded state, the first plate surface 10161 of the first support plate 1016, the third plate surface 10171 of the second support plate 1017, and a support surface of the main shaft 1013 may be located on a same plane, the first plate surface 10161, the third plate surface 10171, and the support surface may be used to perform flat support on the bendable part of the flexible display 4.

It can be learned from the descriptions of the structure of the main shaft module 101 in the foregoing embodiment that the first housing mounting bracket 1014 may drive the first support arm 10112 and the first swing arm 10111 to rotate around the main shaft 1013, and the second housing mounting bracket 1015 may drive the second support arm 10122 and the second swing arm 10121 to rotate around the main shaft 1013. Based on this, it may be considered that the first support plate 1016 may be driven to rotate around the first housing mounting bracket 1014 through rotation of the first support arm 10112 and/or the first swing arm 10111 around the main shaft 1013. Similarly, the second support plate 1017 may also be driven to rotate around the second housing mounting bracket 1015 through rotation of the second support arm 10122 and/or the second swing arm 10121 around the main shaft 1013.

During specific implementation, still refer to FIG. 7. The second plate surface 10162 of the first support plate 1016 may be provided with a first guide portion 101622, and the first guide portion 101622 may include a first track groove 1016221. In addition, in this application, as shown in FIG. 6, the first swing arm 10111 may be provided with a first guide structure 101112. The first guide structure 101112 may be but is not limited to a columnar structure, and the first guide structure 101112 may be inserted into the first track groove 1016221 of the first guide portion 101622 of the first support plate 1016, and may slide along the first track groove 1016221. In this way, in a process in which the first support arm 10112 rotates around the main shaft 1013, the first guide structure 101112 slides in the first track groove 1016221, to drive the first support plate 1016 to rotate around the first housing mounting bracket 1014.

It may be understood that, in this application, a motion track of the first support plate 1016 may be adjusted by adjusting a form of the first track groove 1016221. For example, in the embodiment shown in FIG. 6, the first track groove 1016221 may be an arc-shaped groove.

In another possible embodiment of this application, the first support arm 10112 may further drive the first support plate 1016 to rotate around the first housing mounting bracket 1014. In this case, the first guide structure 101112 may be disposed on the first support arm 10112, so that a driving manner of the first support arm 10112 for the first support plate 1016 is similar to a driving manner of the first swing arm 10111 for the first support plate 1016. Details are not described herein again.

In addition, in some embodiments of this application, guide structures may be disposed on both the first swing arm 10111 and the first support arm 10112, and guide portions are respectively disposed on the second plate surface 10162 of the first support plate 1016 corresponding to a guide structure of the first support arm 10112 and a guide structure of the first swing arm 10111. In this way, the guide structure of the first swing arm 10111 slides in a track groove of the corresponding guide portion of the first support plate 1016, and the guide structure of the first support arm 10112 slides in a track groove of the corresponding guide portion of the first support plate 1016, to implement that the first swing arm 10111 and the first support arm 10112 drive the first support plate 1016 to rotate around the first housing mounting bracket 1014.

In this embodiment of this application, a driving manner in which the second support plate 1017 rotates around the second housing mounting bracket 1015 may be set by referring to the foregoing driving manner in which the first support plate 1016 rotates around the second housing mounting bracket 1015. Details are not described herein again.

It can be understood from the foregoing descriptions of the hinge mechanism 1 provided in this application that, in a process in which the hinge mechanism 1 changes from the unfolded state to the closed state, the first housing mounting bracket 1014 and the second housing mounting bracket 1015 rotate towards each other, the first support arm 10112 and/or the first swing arm 10111 drive one end that is of the first support plate 1016 and that is close to the main shaft 1013 to move in a direction away from the main shaft 1013, and the second support arm 10122 and/or the second swing arm 10121 drive one end that is of the second support plate 1017 and that is close to the main shaft 1013 to move in the direction away from the main shaft 1013. In this way, refer to FIG. 8. FIG. 8 is a diagram of a structure of the main shaft module 101 when a hinge mechanism is in a closed state according to an embodiment of this application. In this case, in the closed state, the first support plate 1016, the second support plate 1017, and the main shaft 1013 may form a screen accommodating space 7.

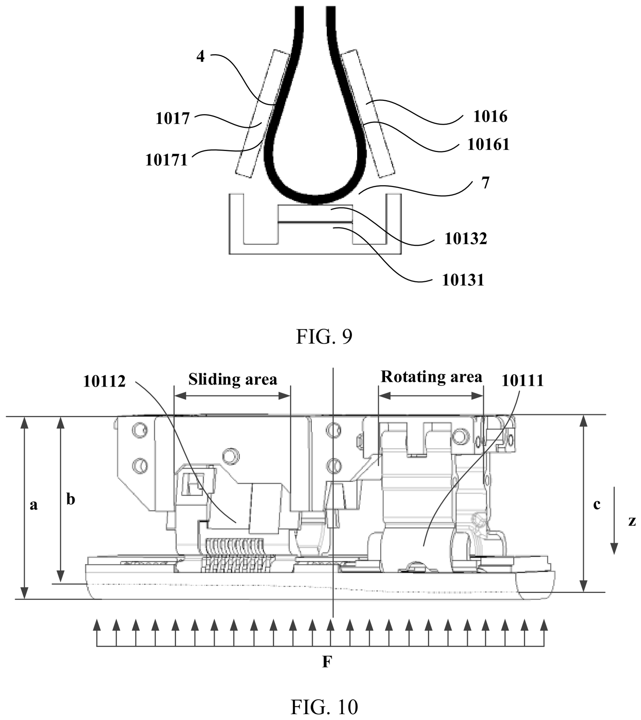

In addition, because the first plate surface 10161 of the first support plate 1016 and the third plate surface 10171 of the second support plate 1017 may be configured to connect to the flexible display 4, when the electronic device is in the closed state, the bendable part of the flexible display 4 may be accommodated in the screen accommodating space 7. Specifically, refer to FIG. 9. FIG. 9 is a block diagram of a structure in which the hinge mechanism 1 in the closed state shown in FIG. 8 cooperates with a bendable part of the flexible display 4. It can be learned from FIG. 9 that, the hinge mechanism 1 provided in this application is used, so that in the closed state, the screen accommodating space 7 may be formed between the first plate surface 10161 of the first support plate 1016, the third plate surface 10171 of the second support plate 1017, and a surface that is of the main shaft 1013 and that faces the first support plate 1016 and the second support plate 1017. In this way, the bendable part of the flexible display 4 of the electronic device may form a water drop-like form when being accommodated in the screen accommodating space 7.

FIG. 10 is a side view of the main shaft module 101 shown in FIG. 8, and may be used to show a structure of a side of the first rotating component 1011 of the main shaft module 101 when the hinge mechanism is in the closed state. It can be understood from the foregoing descriptions of the specific structure of the main shaft module 101 in this embodiment of this application that, in the first rotating component 1011 and the second rotating component 1012, the first support arm 10112 and the second support arm 10122 are respectively slidably connected to corresponding housing mounting brackets, and the first swing arm 10111 and the second swing arm 10121 are respectively rotatably connected to corresponding housing mounting brackets. In this case, when the first rotating component 1011 and the second rotating component 1012 are symmetrically disposed relative to the main shaft 1013, the main shaft module 101 may be divided into a sliding area and a rotating area in the axial direction, where the sliding area is an area in which the first support arm 10112 and the second support arm 10122 are located, and the rotating area is an area in which the first swing arm 10111 and the second swing arm 10121 are located.

In this application, force simulation analysis may be performed on the main shaft module 101 in the closed state. For example, simulation analysis may be performed on the main shaft module 101 in a scenario in which the electronic device falls, where the hinge mechanism 1 is a main stressed component, to understand a deformation trend of the main shaft module 101 in the falling scenario. During specific implementation, in FIG. 10, a direction Z is used to indicate a falling direction of the electronic device. In this case, an external load F acts on the main outer shaft 10131 in a direction from the main outer shaft 10131 to the main inner shaft 10132 (which may also be understood as a direction -Z).

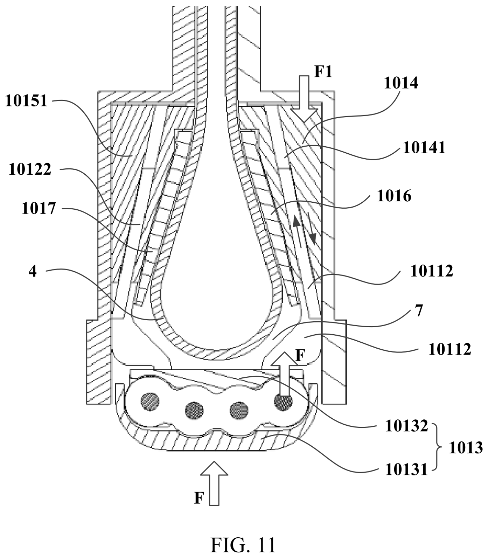

FIG. 11 is a sectional view of the main shaft module 101 in a closed state in the conventional technology according to an embodiment of this application. FIG. 11 is used to show force transmission and motion trends between components in the sliding area of the main shaft module 101 when the main shaft module 101 in the foregoing falling scenario in the conventional technology and the main shaft 1013 is subjected to the external load F. Specifically, as shown in FIG. 11, the first support arm 10112 is rotatably connected to the main shaft 1013, and in this case, the external load F received by the main shaft 1013 may be transmitted to the first support arm 10112 via a revolute pair between the main shaft 1013 and the first support arm 10112. In addition, there is no direct connection relationship between the first housing mounting bracket 1014 and the main shaft 1013. In this case, in the falling scenario, when the main shaft 1013 is subjected to the external load F, the first housing mounting bracket 1014 is subjected to a reaction force F1 due to inertia, and the reaction force F1 received by the first housing mounting bracket 1014 and the external load F are equal in magnitude and opposite in direction. In this case, the force F received by the first support arm 10112 and the force F1 received by the first housing mounting bracket are equal in magnitude and opposite in direction. In addition, the first support arm 10112 is mounted to the first sliding groove 10141 of the first housing mounting bracket 1014, and in this case, the first support arm 10112 and the first housing mounting bracket 1014 may be displaced. Similarly, under the action of the external load F, a motion trend of the second support arm 10122 is similar to that of the first support arm 10112, and in this case, a part that is of the main shaft 1013 and that is located in the sliding area moves towards a direction of the first housing mounting bracket 1014 and the second housing mounting bracket 1015.

Because the main shaft module 101 shown in FIG. 11 is under the action of the external load F, the main shaft 1013 may deform to some extent. In addition, a direction of the external load F is basically consistent with a direction in which each support arm slides relative to the housing mounting bracket, and the part that is of the main shaft 1013 and that is located in the sliding area cannot be effectively supported. In this case, the main shaft 1013 may deform along a shape of a dashed line shown in FIG. 10. It can be learned from FIG. 10 that, after the main shaft module 101 deforms, a collapse amount of the sliding area of the main shaft module 101 is (a-b), and a collapse amount of the rotating area is (a-c), where a is a height that is of the main shaft module 101 shown in FIG. 11 and that is in the direction from the main outer shaft 10131 to the main inner shaft 10132 before the main shaft module 101 deforms, b is a height that is of the sliding area of the main shaft module 101 shown in FIG. 11 and that is in the direction from the main outer shaft 10131 to the main inner shaft 10132 after the main shaft module 101 deforms, and c is a height that is of the rotating area of the main shaft module 101 shown in FIG. 11 and that is in the direction from the main outer shaft 10131 to the main inner shaft 10132 after the main shaft module 101 deforms.

It can be learned from the foregoing simulation analysis that, in the foregoing falling scenario, in the hinge mechanism 1 in the conventional technology, the collapse amount of the sliding area of the main shaft module 101 may be significantly greater than the collapse amount of the rotating area of the main shaft module 101. With reference to the foregoing descriptions of the screen accommodating space 7 formed by the hinge mechanism 1 in the closed state, it may be understood that, the main shaft module 101 is under the action of the external load F, a gap between the main shaft 1013 and the bendable part of the flexible display 4 accommodated in the screen accommodating space 7 is reduced, and a gap between the part that is of the main shaft 1013 and that is located in the sliding area and the bendable part of the flexible display 4 is smaller than a gap between a part that is of the main shaft 1013 and that is located in the rotating area and the bendable part of the flexible display 4. Based on this, how to reduce a deformation amount of the part that is of the main shaft 1013 and that is located in the sliding area is a key to reducing a risk of squeezing caused by the hinge mechanism 1 to the bendable part of the flexible display 4.

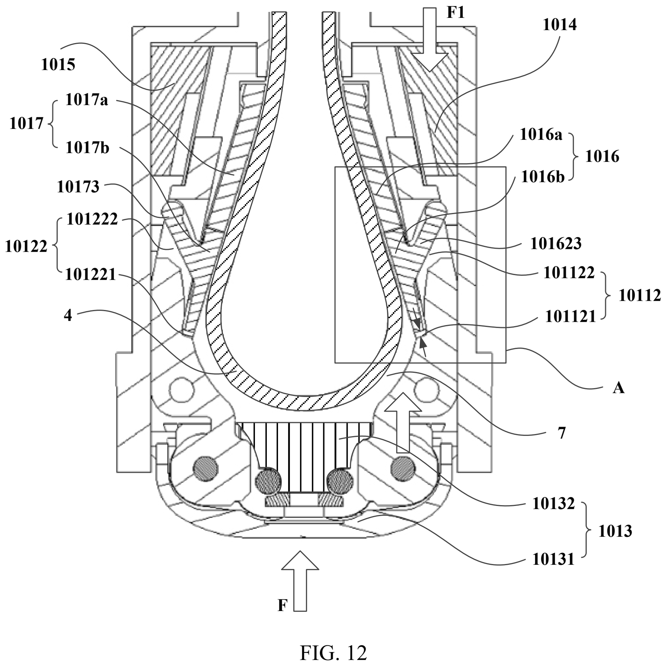

To resolve the foregoing problem, in this application, the structure of the main shaft module 101 is improved, to change an internal force transmission path of the main shaft module 101, so as to reduce the collapse amount of the sliding area of the main shaft module 101. During specific implementation, refer to FIG. 12. FIG. 12 is a sectional view of the first support arm 10112 and the second support arm 10122 of the main shaft module 101 in a closed state according to an embodiment of this application. In this application, the first support arm 10112 includes a first step surface 101121. In the closed state shown in FIG. 12, at least a part of an end part that is of the first support plate 1016 and that is close to the main shaft 1013 is disposed opposite to the first step surface 101121. In this case, a projection of the end part that is of the first support plate 1016 and that is close to the main shaft 1013 in a direction from the main inner shaft 10132 to the main outer shaft 10131 at least partially overlaps a projection of the first step surface 101121 in the direction from the main inner shaft 10132 to the main outer shaft 10131.

Still refer to FIG. 12. FIG. 12 further shows an internal force transmission path of the main shaft module 101 when the main shaft module 101 is subjected to the external load F. Specifically, the external load F received by the main shaft 1013 may be transmitted to the first support arm 10112 via the revolute pair between the main shaft 1013 and the first support arm 10112. In addition, the first housing mounting bracket 1014 is subjected to the reaction force F1, and the reaction force F1 may be transmitted to the first support plate 1016 via a revolute pair between the first housing mounting bracket 1014 and the first support plate 1016. However, in the main shaft module 101 provided in this application, the at least a part of the end part that is of the first support plate 1016 and that is close to the main shaft 1013 is disposed opposite to the first step surface 101121 of the first support arm 10112. In this case, when the main shaft module 101 is subjected to the external load F, the at least a part of the end part that is of the first support plate 1016 and that is close to the main shaft 1013 may abut against the first step surface 101121 of the first support arm 10112, so that a displacement amount between the first support arm 10112 and the first housing mounting bracket 1014 can be effectively reduced, to limit a deformation amount of the main shaft 1013.

For disposition of the second support arm 10122, refer to that of the first support arm 10112. In this case, the second support arm 10122 may include a second step surface 101221. When the hinge mechanism is in the closed state, at least a part of an end part that is of the second support plate 1017 and that is close to the main shaft 1013 is disposed opposite to the second step surface 101221. In other words, a projection of the end part that is of the second support plate 1017 and that is close to the main shaft 1013 in the direction from the main inner shaft 10132 to the main outer shaft 10131 at least partially overlaps a projection of the second step surface 101221 in the direction from the main inner shaft 10132 to the main outer shaft 10131. In this way, when the main shaft module 101 is subjected to the external load F, the at least a part of the end part that is of the second support plate 1017 and that is close to the main shaft 1013 may abut against the second step surface 101221 of the second support arm 10122, to reduce a displacement amount between the second support arm 10122 and the second housing mounting bracket 1015, so as to limit the deformation amount of the main shaft 1013 and improve structural reliability of the main shaft module 101.

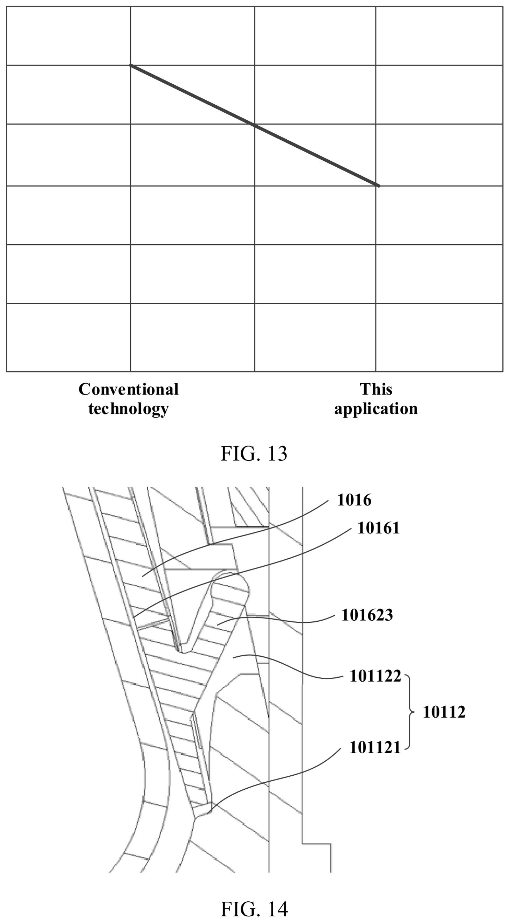

FIG. 13 is a micro-strain comparison diagram of the flexible display 4 when the main shaft module 101 shown in FIG. 11 and the main shaft module 101 shown in FIG. 12 are subjected to an external load F. A vertical coordinate is a micro-strain value of the flexible display 4 when the main shaft module 101 is subjected to the external load F. It can be learned from FIG. 13 that, compared with a micro-strain value of the flexible display 4 generated when the main shaft module in the conventional technology shown in FIG. 11 is subjected to the external load F, a micro-strain value of the flexible display 4 generated when the main shaft module 101 in this application shown in FIG. 12 is subjected to the external load F is significantly reduced. Based on this, it may be understood that, when the main shaft module 101 provided in this embodiment of this application is subjected to the external load F, the at least a part of the end part that is of the first support plate 1016 and that is close to the main shaft 1013 may abut against the first step surface 101121 of the first support arm 10112, and the at least a part of the end part that is of the second support plate 1017 and that is close to the main shaft 1013 abut against the second step surface 101221 of the second support arm 10122. In this way, a displacement amount between each support arm and a corresponding housing mounting bracket can be effectively reduced, to limit the deformation amount of the main shaft 1013, so as to effectively reduce a strain caused by the deformation of the main shaft 1013 on the flexible display 4. Therefore, the hinge mechanism 1 provided in this embodiment of this application can effectively reduce a risk of a failure of the flexible display 4 due to squeezing, and help prolong a service life of the flexible display 4.

In addition, refer to FIG. 14. FIG. 14 is an enlarged diagram of a partial structure of a location A of the main shaft module 101 shown in FIG. 12. In this embodiment of this application, the first support plate 1016 includes a first latch hook 101623, the first latch hook 101623 is located on a side that is of the first support plate 1016 and that is away from the first plate surface 10161, and an included angle that is between the first plate surface 10161 and an extension direction of the first latch hook 101623 and that is away from the main shaft 1013 is an acute angle. However, the first support arm 10112 further includes a first latch slot 101122. In this case, when the main shaft module 101 is in the closed state shown in FIG. 13, the first latch hook 101623 interlocks with the first latch slot 101122. In this way, when the main shaft module 101 is subjected to the external load F, the first latch hook 101623 may interlock with the first latch slot 101122, to prevent the end part that is of the first support plate 1016 and that is close to the main shaft 1013 from sliding off the first step surface 101121, so as to improve abutting reliability of the first support plate 1016 and the first support arm 10112, and improve structural reliability of the hinge mechanism 1.

When the main shaft module 101 is subjected to the external load F, the first support plate 1016 is subjected to a large force. To improve structural reliability of the first support plate 1016, in a possible embodiment of this application, a strength of the end part that is of the first support plate 1016 and that is close to the main shaft 1013 may be large. During specific implementation, still refer to FIG. 12. The first support plate 1016 includes a first plate portion 1016a and a second plate portion 1016b, and the first plate portion 1016a is fastened to the second plate portion 1016b. A connection manner thereof may be but is not limited to welding, riveting, threaded connection, or the like. In this application, a strength of the second plate portion 1016b is greater than a strength of the first plate portion 1016a, and the second plate portion 1016b is disposed close to the main shaft relative to the first plate portion 1016a, so that the strength of the end part that is of the first support plate 1016 and that is close to the main shaft 1013 is large. This can reduce a risk of damage to the first support plate 1016.

During actual design, the first plate portion 1016a may be made of a material with a light weight like aluminum, and the second plate portion 1016b may be made of a material with a high structural strength like stainless steel. In this way, the structural reliability of the first support plate 1016 is ensured, and an overall weight of the first support plate 1016 can be prevented from being excessively large, to meet a lightweight design requirement of the hinge mechanism 1.

It may be understood that, in this application, the first latch hook 101623 may be disposed on the second plate portion 1016b. In addition, the first latch hook 101623 and the second plate portion 1016b may further be of an integrated structure, and in this case, materials of the first latch hook 101623 and the second plate portion 1016b may be the same. This can improve integration of the first support plate 1016 while improving structural reliability of the first latch hook 101623, to help simplify the structure of the main shaft module 101.

Still refer to FIG. 12. The second support plate 1017 includes a second latch hook 10173, the second latch hook 10173 is located on a side that is of the second support plate 1017 and that is away from the third plate surface 10171, and an included angle that is between the third plate surface 10171 and an extension direction of the second latch hook 10173 and that is away from the main shaft 1013 is an acute angle. The second support arm 10122 further includes a second latch slot 101222. In this case, when the main shaft module 101 is in the closed state shown in FIG. 12, the second latch hook 10173 interlocks with the second latch slot 101222. In this way, when the main shaft module 101 is subjected to the external load F, the second latch hook 10173 may interlock with the second latch slot 101222, to prevent the end part that is of the second support plate 1017 and that is close to the main shaft 1013 from sliding off the second step surface 101221, to improve abutting reliability of the second support plate 1017 and the second support arm 10122, and improve structural reliability of the hinge mechanism 1.

In addition, to improve structural reliability of the second support plate 1017, the second support plate 1017 may also be disposed with reference to the first support plate 1016. To be specific, the second support plate 1017 includes a third plate portion 1017a and a fourth plate portion 1017b, and the third plate portion 1017a is fastened to the fourth plate portion 1017b. A connection manner thereof may be but is not limited to welding, riveting, threaded connection, or the like. A strength of the fourth plate portion 1017b is greater than a strength of the second plate portion 1016b, and the fourth plate portion 1017b is disposed close to the main shaft relative to the third plate portion 1017a, so that the strength of the end part that is of the second support plate 1017 and that is close to the main shaft 1013 is large. This can reduce a risk of damage to the second support plate 1017.

In this application, for disposition of the third plate portion 1017a of the second support plate 1017, refer to that of the first plate portion 1016a of the first support plate 1016, and for disposition of the fourth plate portion 1017b of the second support plate 1017, refer to that of the second plate portion 1016b of the first support plate 1016. Details are not described herein again.

In addition, the second latch hook 10173 may be disposed on the fourth plate portion 1017b, and the second latch hook 10173 and the fourth plate portion 1017b may be of an integrated structure. In this case, materials of the second latch hook 10173 and the fourth plate portion 1017b may be the same. This can improve integration of the second support plate 1017 while improving structural reliability of the second latch hook 10173, to help simplify the structure of the main shaft module 101.

In some possible embodiments of this application, the first support plate 1016 may alternatively be of an integrated structure, and each part of the first support plate 1016 adopts a material with a high structural strength, so that the first support plate 1016 has higher structural reliability. Similarly, the second support plate 1017 may alternatively be of an integrated structure, and each part of the second support plate 1017 adopts a material with a high structural strength, so that the second support plate 1017 has higher structural reliability.

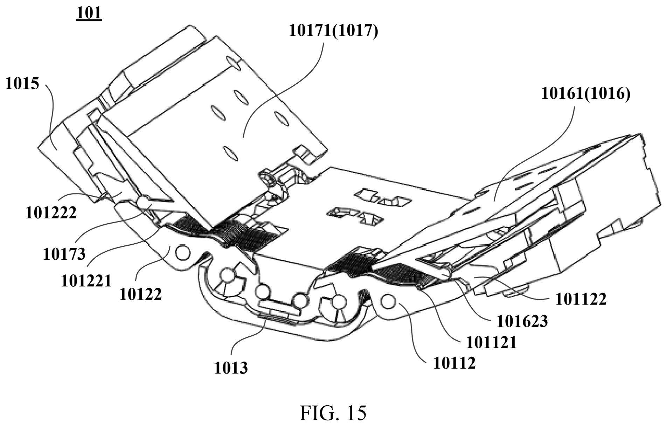

FIG. 15 is a diagram of a structure of the main shaft module 101 in an intermediate state according to an embodiment of this application. FIG. 15 may be understood as showing an intermediate state in a process in which the main shaft module 101 changes from the closed state shown in FIG. 8 to the unfolded state shown in FIG. 4. It may be understood that, in the main shaft module 101 provided in this application, in a process in which the first housing mounting bracket 1014 drives the first support arm 10112 and the first support plate 1016 to rotate, the end part that is of the first support plate 1016 and that is close to the main shaft 1013 may not interfere with the first step surface 101121 of the first support arm 10112. Similarly, in a process in which the second housing mounting bracket 1015 drives the second support arm 10122 and the second support plate 1017 to rotate, the end part that is of the second support plate 1017 and that is close to the main shaft 1013 may not interfere with the second step surface 101221 of the second support arm 10122. Such a design can effectively improve motion reliability of the main shaft module 101, to improve motion reliability of the hinge mechanism 1.

In addition, it can be learned from comparison between FIG. 12 and FIG. 15 that, in a process in which the main shaft module 101 changes from the closed state to the unfolded state, the first latch hook 101623 of the first support plate 1016 is detached from the first latch slot 101122 of the first support arm 10112, and the second latch hook 10173 of the second support plate 1017 is detached from the second latch slot 101222 of the second support arm 10122. In this case, in the hinge mechanism 1 provided in this application, when the main shaft module 101 is in the closed state, the first latch hook 101623 interlocks with the first latch slot 101122, and the second latch hook 10173 interlocks with the second latch slot 101222, so that abutting reliability of the first support plate 1016 and the first support arm 10112 and abutting reliability of the second support plate 1017 and the second support arm 10122 are improved. In a process in which the first housing mounting bracket 1014 and the second housing mounting bracket 1015 drive the first support plate 1016 and the second support plate 1017 to rotate, because the first latch hook 101623 is detached from the first latch slot 101122, and the second latch hook 10173 is detached from the second latch slot 101222, a design of each latch hook and a corresponding latch slot may not interfere with rotation of the first support plate 1016 and the second support plate 1017.

In the hinge mechanism 1 provided in this application, the step surface is disposed on the support arm slidably connected to the housing mounting bracket, and when the electronic device is in the closed state, the at least a part of the end part that is of the support plate rotatably connected to the housing mounting bracket and that is close to the main shaft 1013 can be disposed opposite to the corresponding step surface. In this way, when the hinge mechanism 1 is impacted by the external load, the at least a part of the end part that is of the support plate and that is close to the main shaft 1013 abuts against the corresponding step surface, so that the internal force transmission path of the main shaft module 101 is effectively improved, to reduce a displacement amount between the support arm and the corresponding housing mounting bracket, so as to improve structural reliability of the hinge mechanism 1.

In addition, a design manner of the main shaft module 101 of the hinge mechanism 1 provided in this application may not affect structural strengths of components in the main shaft module 101, so that an overall structural strength of the hinge mechanism 1 can be ensured.

When the hinge mechanism 1 provided in this application is used in the electronic device, and the electronic device is in the closed state, the bendable part of the flexible display 4 is accommodated in the screen accommodating space 7 formed by the first support plate 1016, the second support plate 1017, and the main shaft 1013. Because the deformation amount of the main shaft module 101 of the hinge mechanism 1 under impact of the external load is small, a risk of collision between an internal part of the hinge mechanism 1 and the bendable part of the flexible display 4 is small. This can effectively reduce a risk of damage to the flexible display 4 due to squeezing, to improve structural reliability of the electronic device.

It should be understood that a specific disposing manner of the hinge mechanism 1 provided in this embodiment of this application is not limited thereto. Based on the foregoing descriptions of a design principle of the hinge mechanism 1, the specific structure of the hinge mechanism 1 may be adaptively adjusted based on a specific application scenario. Details are not described herein, but all of them shall be understood as falling within the protection scope of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subjected to the protection scope of the claims.

## Claims

1. A hinge mechanism, used in a foldable electronic device, wherein the hinge mechanism is at least partially disposed corresponding to a bendable part of a flexible display of the electronic device, the hinge mechanism comprises a main shaft module, a first support plate, and a second support plate, the main shaft module comprises a first rotating component, a second rotating component, a first housing mounting bracket, a second housing mounting bracket, and a main shaft, and the first rotating component and the second rotating component are located on two opposite sides of the main shaft, wherein
the first rotating component comprises a first support arm, the first support arm is rotatably connected to the main shaft, the first support arm is slidably connected to the first housing mounting bracket, and the first support arm comprises a first step surface;
the second rotating component comprises a second support arm, the second support arm is rotatably connected to the main shaft, the second support arm is slidably connected to the second housing mounting bracket, and the second support arm comprises a second step surface;
the first support plate is rotatably connected to the first housing mounting bracket, the first support plate comprises a first plate surface, and the first plate surface is configured to connect to the flexible display;
the second support plate is rotatably connected to the second housing mounting bracket, the second support plate comprises a third plate surface, and the third plate surface is configured to connect to the flexible display; and
when the hinge mechanism is in a closed state, a screen accommodating space is formed between the first plate surface of the first support plate, the third plate surface of the second support plate, and a surface that is of the main shaft and that faces the first support plate and the second support plate; and at least a part of an end part that is of the first support plate and that is close to the main shaft is disposed opposite to the first step surface, and at least a part of an end part that is of the second support plate and that is close to the main shaft is disposed opposite to the second step surface.

2. The hinge mechanism according to claim 1, wherein the main shaft comprises a main inner shaft and a main outer shaft, and the main inner shaft and the main outer shaft are disposed in a snap-fit manner; and
when the hinge mechanism is in the closed state, a projection of the end part that is of the first support plate and that is close to the main shaft in a direction from the main inner shaft to the main outer shaft at least partially overlaps a projection of the first step surface in the direction from the main inner shaft to the main outer shaft; and a projection of the end part that is of the second support plate and that is close to the main shaft in the direction from the main inner shaft to the main outer shaft at least partially overlaps a projection of the second step surface in the direction from the main inner shaft to the main outer shaft.

3. The hinge mechanism according to claim 1 or 2, wherein the first support plate comprises a first latch hook, the first latch hook is located on a side that is of the first support plate and that is away from the first plate surface, and an included angle that is between the first plate surface and an extension direction of the first latch hook and that is away from the main shaft is an acute angle; and the first support arm further comprises a first latch slot, and when the hinge mechanism is in the closed state, the first latch hook interlocks with the first latch slot; and
the second support plate comprises a second latch hook, the second latch hook is located on a side that is of the second support plate and that is away from the third plate surface, and an included angle that is between the third plate surface and an extension direction of the second latch hook and that is away from the main shaft is an acute angle; and the second support arm further comprises a second latch slot, and when the hinge mechanism is in the closed state, the second latch hook interlocks with the second latch slot.

4. The hinge mechanism according to claim 3, wherein the first support plate comprises a first plate portion and a second plate portion, the first plate portion is fastened to the second plate portion, a strength of the second plate portion is greater than a strength of the first plate portion, and the second plate portion is disposed close to the main shaft relative to the first plate portion; and
the second support plate comprises a third plate portion and a fourth plate portion, the third plate portion is fastened to the fourth plate portion, a strength of the fourth plate portion is greater than a strength of the third plate portion, and the fourth plate portion is disposed close to the main shaft relative to the third plate portion.

5. The hinge mechanism according to claim 4, wherein a material of the first plate portion is aluminum, a material of the second plate portion is stainless steel, and the first plate portion is welded to the second plate portion; and a material of the third plate portion is aluminum, a material of the fourth plate portion is stainless steel, and the third plate portion is welded to the fourth plate portion.

6. The hinge mechanism according to claim 4 or 5, wherein the first latch hook and the second plate portion are of an integrated structure; and the second latch hook and the fourth plate portion are of an integrated structure.

7. The hinge mechanism according to any one of claims 1 to 6, wherein the first housing mounting bracket comprises a first sliding groove, and the first support arm is slidably mounted to the first sliding groove; and
the second housing mounting bracket comprises a second sliding groove, and the second support arm is slidably mounted to the second sliding groove.

8. The hinge mechanism according to any one of claims 1 to 7, wherein the first rotating component further comprises a first swing arm, the first swing arm is rotatably connected to the main shaft, the first swing arm is rotatably connected to the first housing mounting bracket, and an axis along which the first swing arm rotates around the main shaft is parallel to and does not overlap an axis along which the first support arm rotates around the main shaft; and
the second rotating component further comprises a second swing arm, the second swing arm is rotatably connected to the main shaft, the second swing arm is rotatably connected to the second housing mounting bracket, and an axis along which the second swing arm rotates around the main shaft is parallel to and does not overlap an axis along which the second support arm rotates around the main shaft.

9. The hinge mechanism according to claim 8, wherein the main shaft is provided with a first arc-shaped groove and a second arc-shaped groove, the first swing arm comprises a first arc-shaped rotating block, and the first arc-shaped rotating block is mounted to the first arc-shaped groove, and is capable of sliding along a groove surface of the first arc-shaped groove; and
the second swing arm comprises a second arc-shaped rotating block, and the second arc-shaped rotating block is mounted to the second arc-shaped groove, and is capable of sliding along a groove surface of the second arc-shaped groove.

10. The hinge mechanism according to claim 8 or 9, wherein the first support plate further comprises a second plate surface, the second plate surface is disposed opposite to the first plate surface, a first rotating portion is disposed on the second plate surface, the first housing mounting bracket is provided with a first rotating groove, the first rotating portion is mounted to the first rotating groove, and the first rotating portion is capable of sliding along a groove surface of the first rotating groove; and
the second support plate further comprises a fourth plate surface, the fourth plate surface is disposed opposite to the third plate surface, a second rotating portion is disposed on the fourth plate surface, the second housing mounting bracket is provided with a second rotating groove, the second rotating portion is mounted to the second rotating groove, and the second rotating portion is capable of sliding along a groove surface of the second rotating groove.

11. The hinge mechanism according to claim 10, wherein the second plate surface of the first support plate is further provided with a first guide portion, the first guide portion comprises a first track groove, at least one of the first support arm and the first swing arm is provided with a first guide structure, and the first guide structure is inserted into the first track groove, and is capable of sliding along the first track groove; and
the fourth plate surface of the second support plate is further provided with a second guide portion, the second guide portion comprises a second track groove, at least one of the second support arm and the second swing arm is provided with a second guide structure, and the second guide structure is inserted into the second track groove, and is capable of sliding along the second track groove.

12. An electronic device, comprising a first housing, a second housing, a flexible display, and the hinge mechanism according to any one of claims 1 to 11, wherein
the first housing and the second housing are respectively disposed on two opposite sides of the hinge mechanism, the first housing mounting bracket is fastened to the first housing, and the second housing mounting bracket is fastened to the second housing; and
the flexible display continuously covers the first housing, the second housing, and the hinge mechanism, and the flexible display is fastened to the first housing and the second housing.
